# EUROPÄISCHE PATENTANMELDUNG

(11) **EP 2 503 391 A2**
(43) Veröffentlichungstag der Anmeldung: **26.09.2012**
(21) Anmeldenummer: 12001794.2
(22) Anmeldetag: 16.03.2012
(51) Int. Cl.: G03F 7/00, G03F 7/004, G03F 7/031, G03F 7/24

(54) **Verwendung dualhärtbarer Zusammensetzungen zur Beschichtung**

(30) Priorität: 25.03.2011 DE 102011015223
(71) Anmelder: Heraeus Kulzer GmbH & Co. KG, 63450 Hanau (DE)
(72) Erfinder: Eppinger, Bernhard, 35781 Weilburg (DE); Fremdt-Sachse, Sonja, 35796 Weinbach (DE); Pohl, Manfred, 61352 Bad Homburg (DE); Klingberg, Daniel, 61381 Friedrichsdorf (DE); Bodmer, Alex, 8840 Einsiedeln (CH)
(74) Vertreter: Kühn, Hans-Christian

(57) **Zusammenfassung**

Dualhärtende polymerisierbare Zusammensetzungen umfassend
● mindestens ein (Meth-)acrylat,
● eine Kombination umfassend mindestens einen Photoinitiator und heißhärtenden Initiator,
● ein Gehalt an Pigment oder Farbstoff,
● gegebenenfalls ein Gehalt an Füllstoff,

die stark pigmentiert dunkel oder opak sind, eignen sich gut zur Herstellung dreidimensionaler Schmuckgegenstände, dreidimensionaler Schmuckartikel oder zur Beschichtung, Dekoration, Markierung und/oder Beschriftung eines Substrates aus der Gruppe der Schmuckgegenstände, Werkzeuge oder medizinischen Instrumente, und besonders gut zur Beschichtung stark gekrümmter Gegenstände aus der Gruppe der Schmuckgegenstände, Werkzeuge oder medizinischen Instrumente.

## Beschreibung

Die Erfindung betrifft die Verwendung einer dualhärtenden polymerisierbaren Zusammensetzung umfassend ein Methacrylat und einen Gehalt an Füllstoff sowie eine Kombination eines Photoinitiators und eines heißhärtenden Initiators sowie gegebenenfalls einen Aktivator, Verfahren zu ihrer Herstellung als auch ihre Verwendung zur Herstellung von Beschichtungen auf Materialien, Schmuckgegenständen und farbigen Überzügen zur Identifizierung von Werkzeugen.

JP-A-59086604 und JP-A-59086603 offenbaren Zusammensetzungen, die Acrylate, aber keine Füllstoffe enthalten. Sie können mittels Licht gehärtet und zur Herstellung von transparentem Schmuck eingesetzt werden.

Die DE-C-44 12 715 beschreibt die Verwendung von zwei Komponenten Mischungen (2K-Mischungen) mit Edelmetallpulver und Methylmethacrylat-Styrol-Harz mit einem Benzoylperoxid und einer Härterkomponente. Nach dem Mischen der beiden Komponenten härtet die Zusammensetzung über einen längeren Zeitraum aus. Nachteilig an diesen Zusammensetzungen ist die kurze Zeit in der sie korrekt verarbeitet werden können.

Bei der Herstellung metallischer Schmuckgegenstände werden neben einer konventionellen Einfassung von Edelsteinen auch stark gefärbte Emaillen als dekorative Elemente eingesetzt. Diese Emaillen wirken als dekoratives Element minderwertiger Qualität, da sie aufgrund fehlender Transparenz nicht den gewünschten optischen Effekt von Edelsteinen oder Halbedelsteinen bieten. Zudem ist die Aufbringung von Emaillen auf den Schmuckgegenstand durch die erforderlichen hohen Temperaturen sehr aufwendig. Emaillen sind sehr brüchig und daher nicht zur Herstellung komplizierterer dekorativer Elemente, wie ringförmiger Elemente, geeignet. Auf Metallen zeigen Emaillen eine sehr gute Haftung, so dass sie bei erforderlichen Korrekturen nur sehr schwierig, z.B. mittels Flusssäure entfernt werden können.

Die Herstellung lichthärtender Materialien für die Beschichtung und Herstellung von Schmuck ist lange bekannt. So beschreibt die EP 0 864 266 A1 die Verwendung einer Zusammensetzung zur Dekoration von Ringen, die mittels Haftvermittler und Klebstoff auf einen Goldrohling aufgebracht wird und anschließend mit einem Lichthandgerät mit einem Emissionsspektrum von 400 bis 500 nm für 5 bis 10 Sekunden angehärtet wird. Die dort offenbarten Zusammensetzungen können nur zur Aufbringung dünner Beschichtungen eingesetzt werden, da eine Polymerisation mittels Licht einer Beschränkung bei opaken Beschichtungen, d.h. von stark pigmentierten Beschichtungen unterliegt. Dickere Beschichtungen hochpigmentierter Zusammensetzungen härten unter diesen Bedingungen nicht vollständig aus.

Es gibt auch heißhärtende Systeme, also Systeme, die unter Erwärmung polymerisieren. Diese Systeme weisen den Nachteil auf, dass die Aushärtung unter Druck und hoher Temperatur mit einem Wärmeübertragungsmedium, wie bspw. Ethylenglykol, erfolgt.

Aufgabe der vorliegenden Erfindung war es, eine Zusammensetzung einzusetzen, die keine Limitierung bezüglich der aufzubringenden Schichtdicke aufweist, auch bei stark pigmentierten Zusammensetzungen. Ferner sollte die Handhabung der Zusammensetzung wirtschaftlicher sein und eine industrielle Aufbringung der Zusammensetzung sowie ihre Fixierung und Aushärtung erlauben. Dabei sollte möglichst aus wirtschaftlichen und ökologischen Gesichtspunkten auf die Verwendung von Lösemitteln verzichtet werden.

Dualhärtende Beschichtungen sind an sich bekannt: So stellt sich WO 2008122504 A1 zunächst die Aufgabe, Alternativen zu den mit Bisacylphosphin Photinitiatoren verwendeten BAPO Co-Initiatoren zu finden. Gefunden wurden die alpha Hydroxyketone der Formel I. Dann wird beschrieben, dass zusammen mit beispielsweise AIBN dual (simultan) oder doppelt (nacheinander) härtende Zusammensetzungen - u. a. methacrylathaltige - entstehen. Die mangelnde Durchhärtungstiefe vor allem bei pigmentierten Zusammensetzungen kann dadurch verbessert werden. In WO 2008122504 A1 wird eine breite Palette von Anwendungsmöglichkeiten angegeben, darunter decorative coatings - diese aber nur als Klarlack. Auch die Anwesenheit von Füllstoffen ist möglich. Glasfüller werden zur besseren Härtung pigmentierter Zusammensetzungen empfohlen.

Gelöst wird die Aufgabe durch die erfindungsgemäße Verwendung nach Anspruch 1, durch das erfindungsgemäße Verfahren gemäß Anspruch 13 sowie die erfindungsgemäße Verwendung nach den Ansprüchen 15 und 17. Weitere Details bevorzugter Ausführungsformen sind in den Unteransprüchen sowie in der Beschreibung detailliert erläutert.

Gegenstand der Erfindung ist die Verwendung einer dualhärtenden polymerisierbaren Zusammensetzung die mittels einer Vor-Polymerisation mit Licht vorgehärtet wird und anschließend in einem definierten Temperaturbereich ausgehärtet wird. Die Zusammensetzung umfasst mindestens ein (Meth-)acrylat, gegebenenfalls einen Gehalt an Füllstoff und eine Kombination eines Initatorsystems umfassend mindestens einen Photoinitiator und heißhärtenden Initiator sowie gegebenenfalls einen Aktivator. Die Schreibweise (Meth-)acrylat bedeutet, dass die Zusammensetzung ein Methacrylat und/oder ein Acrylat umfassen kann.

Die erfindungsgemäße Verwendung erlaubt eine einfache Handhabung einer polymerisierbaren Zusammensetzung über quasi einen unbestimmten Zeitraum und betrifft zugleich eine einzige Zusammensetzung. Sie weist nicht die Nachteile von 2K-Zusammensetzungen mit nur begrenzter Bearbeitungszeit auf. Ebenso wenig ist ein Wärmeübertragungsmedium, wie bei heißhärtenden Zusammensetzungen notwendig, und es können anders als mit rein Licht härtenden Zusammensetzungen, auch Schichtdicken größer 1 mm in einfacher und wirtschaftlicher Weise hergestellt werden. Als besonderer Vorteil ist die Verwendung in industriellen, automatisierten Verfahren zur Auftragung von Beschichtungen zu nennen, insbesondere von Beschichtungen mit Schichtdicken von größer 0,1 mm bis bspw. 5 mm, insbesondere 1 mm bis 5 mm, bevorzugt von 1 bis 4 mm, besonders bevorzugt 1,1 bis 4 mm auf Substrate, denn durch die Licht induzierte Vor-Polymerisation kann die Zusammensetzung einfach auf dem Substrat fixiert werden und anschließend durch Zufuhr von Wärme ausgehärtet werden.

Eine erfindungsgemäß verwendete Zusammensetzung umfasst mindestens ein (Meth-)acrylat, insbesondere ein Methacrylat, bevorzugt eine Mischung von (Meth-)acrylaten, vorzugsweise mit einem Gehalt an Füllstoff, Farbstoff und/oder Pigment, sowie eine Kombination eines Photoinitiators und eines heißhärtenden Initiators. Vorzugsweise ist der Photoinitiator eine Carbonyl-funktionalisierte Verbindung, wobei die Carbonyl-Verbindung insbesondere kein Peroxid ist. Bevorzugt ist der Photoinitiator ein Benzophenon, ein Benzophenon Derivat, Ethyl - 2,4,6 - Trimethylbenzoylphenylphosphinate, Benzoin oder ein Benzoin-Derivat, ein alpha-Diketon, wie 9,10-Phenantrenchinon, Diacetyl, Furil, Anisil, 4,4'-Dichlorbenzil und 4,4'-Dialkoxybenzil oder ein Acylphosphinoxid und/oder Campherchinon. Ein besonders bevorzugter Photoinitiator ist Campherchinon und/oder Ethyl - 2,4,6 - Trimethylbenzoylphenylphosphinate. Um eine besonders schnell härtende Zusammensetzung zu erhalten ist es von Vorteil den Photoinitiator zusammen mit einem Aktivator einzusetzen. Bevorzugte Aktivatoren sind Reduktionsmittel und insbesondere ein Amin. Besonders bevorzugte Amine sind N,N-Dimethyl-p-toluidin, N,N-Dihydroxyethyl-p-toluidin und insbesondere N,N-Cyanoethylmethylanilin.

Die Photoinitiatoren und Aktivatoren werden vorzugsweise in einer Gesamtmenge von 0,05 bis 2,0 Gew.-%, besonders bevorzugt 0,1 bis 0,8 Gew.-%, in Bezug auf die Gesamtzusammensetzung eingesetzt.

Als problematisch bei der Herstellung einer dualhärtenden Zusammensetzung haben sich übliche heißhärtende Peroxide erwiesen, die nicht zu stabilen, insbesondere lagerstabilen Zusammensetzungen führten. Es stellte sich heraus, dass die Peroxide mit den vorgenannten Aktivatoren reagieren können. Die Herstellung von Mischungen mit üblichen heißhärtenden Peroxiden führte teilweise bereits beim Mischvorgang zur Aushärtung der Zusammensetzung, so dass sie unbrauchbar war bzw. zu kurze Verarbeitungszeiten aufwiesen und nur als zwei-Komponentensystem lagerfähig sind.

Erst durch den Einsatz eines heißhärtenden Initiators, basierend auf einem Azo-bis-Alkylnitril konnten stabile dualhärtbare Zusammensetzungen erhalten werden, die als eine einzige Zusammensetzung vertrieben werden kann. Als besonders bevorzugte heißhärtende Initiatoren haben sich Azo-bis-Alkylnitrile erwiesen, deren Alkylsubstituenten jeweils unabhängig 3 bis 15 C-Atome aufweisen, vorzugsweise mit verzweigten Alkylsubstituenten, besonders bevorzugt mit am C-2 verzweigten Alkylsubstituenten. Die erfindungsgemäßen Azo-bis-alkylnitrile haben eine Aktivierungstemperatur etwa ab 48 °C oder ab 55 °C oder ab 65 °C. Dem Fachmann ist klar, dass die bevorzugte Aktivierungstemperatur von der jeweiligen Anwendung und der Temperaturstabilität des Substrates abhängt, auf das die Zusammensetzung aufgetragen wird. Bei diesen niedrigen Temperaturen ist die Wärme induzierte Polymerisation in der Regel langsam und benötigt bis zu 20 Stunden bis zur vollständigen Aushärtung.

Besonders schnell erfolgt die Wärme induzierte Polymerisation bei höheren Temperaturen, insbesondere im Bereich von 60 °C bis 150 °C, vorzugsweise zwischen 80 °C bis 140 °C, besonders bevorzugt innerhalb von wenigen Minuten bis unter 30 Minuten im Bereich von 100 °C bis 140 °C. Erfindungsgemäß wird AIBN (Azo-bis-Isobutyronitril; 2,2'-Azobis(2-methylpropionitril)) und/oder AMBN (2,2'-Azo-bis(2-Methylbutyronitril) eingesetzt. Die erfindungsgemäßen Azo-bis-Alkylnitrile reagieren nicht mit den in der Zusammensetzung gegebenenfalls vorliegenden Aminen (Aktivatoren). Der heißhärtende Initiator ist erfindungsgemäß kein Peroxid.

Der erfindungsgemäße Vorteil der dualhärtenden Zusammensetzungen ist eine zuverlässige Aushärtung selbst mit stark pigmentierten, dunklen oder opaken Zusammensetzungen. Zudem können selbst dicke Schichten oder auch dreidimensionale Verzierungen oder dreidimensionale Schmuckgegenstände oder Artikel, selbst mit opaken Zusammensetzungen hergestellt werden. Erfindungsgemäß wird bei einer Verwendung der Zusammensetzung zur Herstellung dünner Beschichtungen auf einem Substrat nach einer Licht-induzierten Vor-Polymerisation dem Substrat mit der Beschichtung Wärme zugeführt. Dies ist aufgrund der erfindungsgemäßen Kombination erstmalig in einfacher und wirtschaftlicher Weise in einem Wärmeofen ohne Wärmeübertragungsmedium möglich.

So kann beispielsweise die Zusammensetzung einfach bei 100 bis 130 °C innerhalb von 3 bis 30 Minuten, in Abhängigkeit von der Konzentration des heißhärtenden Initiators eine Beschichtung, insbesondere von 1 bis 4 mm Schichtdicke, ausgehärtet werden. Alternativ kann auch mit einem Temperaturprofil ausgehärtet werden. So kann zu Beginn der Heißhärtung eine Temperatur von bis zu 150 °C eingestellt werden und anschließend im Temperaturbereich zwischen 40 bis 70 °C, besonders bevorzugt um 60 °C weiter ausgehärtet werden. Diese Härtung kann sich beispielsweis anbieten, wenn temperaturempfindliche Substrate schnell beschichtet werden sollen, so dass sie nur kurzzeitig auf hohe Temperaturen erhitzt werden. Über die Wahl der Temperatur und die Konzentration des heißhärtenden Initiators lässt sich die Härtungszeit einstellen. Eine besonders schnelle Aushärtung innerhalb von 3 bis 12 Minuten wird bei hohen Temperaturen zwischen 120 bis 140 °C erzielt. Ein weiterer Vorteil der Dualhärtung ist die stark vereinfachte Handhabung während der Polymerisationszeit.

Bei der reinen Lichthärtung gemäß dem Stand der Technik musste in zwei Stufen polymerisiert werden. So wurde zunächst für 5 bis 10 Sekunden mit 400 bis 500 nm gehärtet und anschließend musste der dekorierte Gegenstand für mindestens 5 Minuten mit einer Lichtquelle mit einem Emissionsspektrum von 300 bis 600 nm bestrahlt werden. Eine Beschichtung von Proben mit Hinterschneidungen oder Nuten war nicht möglich.

Mit der erfindungsgemäßen Verwendung ist nur noch eine kurze Vor-Polymerisation mit einer Lichtquelle notwendig, während die vollständige Aushärtung durch Wärmezufuhr erfolgt. Um eine besonders gute und vollständige Aushärtung zu erzielen empfiehlt es sich die vorpolymerisierte Zusammensetzung in einem handelsüblichen Wärmeofen bei konstanter Temperatur zu halten. Anders als bei anderen rein heißhärtenden Zusammensetzungen ist bei der erfindungsgemäß verwendeten Zusammensetzung aufgrund der Licht induzierten Vor-Polymerisation kein Wärmeübertragungsmedium und auch kein erhöhter Druck zur Aushärtung mehr notwendig.

Ein weiterer Vorteil der erfindungsgemäßen Verwendung liegt darin, dass die durch die Licht induzierte Vor-Polymerisation aufgebaute Spannung in der Zusammensetzung durch die sich anschließende Heißhärtung abgebaut wird. Durch diesen Effekt der Heißhärtung können mit Hilfe der erfindungsgemäßen Verwendung Schmuckgegenstände, Beschichtungen, Artikel oder Verzierungen mit deutlich verbesserten mechanischen Eigenschaften hergestellt werden.

Eine bevorzugt verwendete Zusammensetzung enthält mindestens ein Monomer eines (Meth-) acrylats mit einem aromatischen und/oder aliphatischen Kohlenwasserstoffgrundgerüst, das vorzugsweise ein (Meth-)acrylat mit mindestens zwei (Meth-)acrylat-Endgruppen ist, wie ein Ether eines 2,2'-Bis-(phenol)propans, oder mit einem Alkylenoxy-Grundgerüst mit 2 bis 4 C-Atomen in jeder bifunktionellen Alkylen-Gruppe, wie Ethylenglykol, Triethylenglykol, Tetraethylenglykol oder ein Trimethylolpropan. Eine Zusammensetzung kann vorzugsweise mindestens ein Monomer eines Methacrylats, wie Methylmethacrylat, und ein Monomer eines Acrylats, insbesondere mit mindestens zwei Acrylat-Gruppen enthalten, wie Trimethylolpropan-Triacrylat.

Ein wichtiger Aspekt der Erfindung ist auch die Verwendung von Methacrylaten, die nicht auf die toxikologischen Bedenken wie Acrylate treffen. Einsetzbare Methacrylate sind Methylmethacrylat und vor allem Isobutylmethacrylat und Cyclohexylmethacrylat.

Gemäß einer Alternative kann eine Zusammensetzung auch mindestens ein Monomer eines (Meth-)acrylats, wie Methylmethacrylat, Tetrahydrofurfuryl-Methacrylat (THF-Methacrylat), Isobornyl Methacrylat, Isobornyl Acrylat, 2-Phenoxyethyl-Methacrylat und/oder 2-Phenoxyethyl-Acrylat, enthalten. Bevorzugte Monomere weisen eine sehr geringe Viskosität auf, um ein Fließen der Zusammensetzung in Hohlräume, wie Nuten, Hinterschneidungen oder auch Poren zu erlauben.

Besonders bevorzugt enthält die Zusammensetzung mindestens ein (Meth-)acrylat Monomer mit mindestens zwei (Meth-)acrylat-Gruppen,

Weiter bevorzugt enthält die Zusammensetzung mindestens ein Methacrylat Monomer mit mindestens zwei Methacrylat-Gruppen, denn mit diesen Methacrylaten können nach der Polymerisation sehr schöne dekorative Elemente erhalten werden. Die erhaltenen Elemente weisen auch eine besonders große Härte und Festigkeit auf. Sehr harte, ausgehärtete Materialien sind notwendig, um auch nach längerem Tragen ein Verkratzen der Schmuckgegenstände bzw. ein Mattieren zu unterbinden. Ein wesentlicher Aspekt bei der Herstellung von Zusammensetzungen zur Herstellung von Schmuckgegenständen oder Schmuckelementen ist ein hoher und langanhaltender Glanz der Oberfläche. Zudem zeigen die ausgehärteten Zusammensetzungen eine sehr geringe Schlagempfindlichkeit.

Als besonders bevorzugte Acrylat Monomere mit mindestens zwei Acrylat-Gruppen haben sich die nachfolgenden erwiesen: Trimethylolpropan-tri-Acrylat, Pentaerythrit-tetra-Acrylat.

Gemäß einer Alternative kann eine Zusammensetzung auch mindestens ein Oligomer bzw. Polymer eines (Meth-)acrylats enthalten, wie PMMA (Polymethylmethacrylat) und/oder Urethandi-Acrylat-Oligomer enthalten.

Als besonders bevorzugte Methacrylat Monomere mit mindestens zwei Methacrylat-Gruppen haben sich die nachfolgenden erwiesen: Tetraethylenglykoldimethacrylat, Diethylenglykoldimethacrylat, Etylenglykoldimethacrylat, Trimethylolpropan-trimethacrylat, Pentaerythrit-tetra-Methacrylat, Polyethylenglykoldimethacrylat, Butandioldimethacrylat, Hexandioldimethacrylat, Decandioldimethacrylat und/oder Bisphenol-A-dimethacrylat. Wobei Triethylenglykoldimethacrylat, 2,2-Bis-4-(3-methacryloxy-2-hydroxy-propoxy)-phenylpropan (Bis-GMA) und/oder ein Urethanmethacrylat mit mindestens zwei Methacrylat-Gruppen oder eine Mischung enthaltend eines der Methacrylate besonders bevorzugt sind. Dem Fachmann ist bekannt, das Urethanmethacrylate üblicherweise durch Reaktion von Isocyanaten, insbesondere Di- und/oder Triisocyanaten, mit Methacrylaten mit OH-Gruppen hergestellt werden.

Gemäß einer bevorzugten Ausführungsform der Erfindung umfasst eine Zusammensetzung zu (a) 60 bis 99,7 Gew.-% (Meth-)acrylat, insbesondere 60 bis 97 Gew.-% (Meth-)acrylat, vorzugsweise 70 bis 90 Gew.-% mindestens ein (Meth-) acrylat, bevorzugt 80 bis 90 Gew.-% (Meth-)acrylat, und zu (b) 0,05 bis 2,0 Gew.-% mindestens einen Photoinitiator und gegebenenfalls einen Aktivator und zu (c) 0,02 bis 7,0 Gew.-% mindestens einen heißhärtenden Initiator, insbesondere zu 0,04 bis 5,5 Gew.-%, weiter bevorzugt zu 0,05 bis 5,00 Gew.-% in Bezug auf die Gesamtzusammensetzung von 100 Gew.-%; oder sie enthält ad 100 Gew.-% zusätzlich Farbstoff, Pigment und/oder Füllstoffe, insbesondere Füllstoff.

Gemäß einer alternativen bevorzugten Ausführungsform der Erfindung umfasst eine Zusammensetzung zu (a) 60 bis 99,7 Gew.-% (Meth-)acrylat, insbesondere 60 bis 97 Gew.-%, vorzugsweise 70 bis 90 Gew.-% mindestens ein Acrylat, bevorzugt 80 bis 90 Gew.-% Acrylat, vorzugsweise mindestens eines Acrylat Monomers mit mindestens zwei Acrylat-Gruppen, und zu (b) 0,05 bis 2,0 Gew.-% mindestens einen Photoinitiator und gegebenenfalls einen Aktivator und zu (c) 0,02 bis 7,0 Gew.-% mindestens einen heißhärtenden Initiator, insbesondere zu 0,04 bis 5,5 Gew.-%, weiter bevorzugt zu 0,05 bis 5,00 Gew.-% in Bezug auf die Gesamtzusammensetzung von 100 Gew.-%; oder ad 100 Gew.-% zusätzlich Farbstoff, Pigment und/oder Füllstoffe, insbesondere Füllstoff.

Gemäß einer besonders bevorzugten Ausführungsform der Erfindung umfasst eine Zusammensetzung zu (a) 60 bis 99,7 Gew.-% mindestens ein Methacrylat, insbesondere 60 bis 97 Gew.-%, vorzugsweise 70 bis 90 Gew.-% mindestens ein Methacrylat, bevorzugt 80 bis 90 Gew.-% Methacrylat, vorzugsweise mindestens eines Methacrylat Monomers mit mindestens zwei Methyacrylat-Gruppen, und zu (b) 0,05 bis 2,0 Gew.-% mindestens einen Photoinitiator und gegebenenfalls einen Aktivator und zu (c) 0,02 bis 7,0 Gew.-% mindestens einen heißhärtenden Initiator, insbesondere zu 0,04 bis 5,5 Gew.-%, weiter bevorzugt zu 0,05 bis 5,00 Gew.-% in Bezug auf die Gesamtzusammensetzung auf 100 Gew.-%; oder ad 100 Gew.-% zusätzlich Farbstoff, Pigment und/oder Füllstoffe, insbesondere Füllstoff.

Gemäß einer weiteren alternativen, besonders bevorzugten Ausführungsform der Erfindung umfasst eine Zusammensetzung zu (a) 60 bis 99,7 Gew.-% (Meth-)acrylat, insbesondere 60 bis 97 Gew.-% (Meth-)acrylat ausgewählt aus mindestens einem (Meth-)acrylat Monomer und einem (Meth-)acrylat Oligomer (synonym auch Polymer), insbesondere weist das Oligomer mehr als drei polymerisierte (Meth-) acrylate auf, vorzugsweise enthält das Oligomer kein aromatisches und/oder aliphatisches Kohlenwasserstoffgrundgerüst oder kein Alkylenoxy-Grundgerüst mit 2 bis 4 C-Atomen in jeder Alkylen-Gruppe. Dies können als Monomer Methylmethacrylat, Trimethylolpropan-triacrylat, Trimethylolpropan-trimethacrylat, 2-Phenoxyethyl-methylacrylat und/oder 2-Phenoxyethyl-acrylat, Tetrahydrofuryl-methacrylat, Isobornyl Methacrylat und/oder Isobornyl Acrylat sein. Als Oligomer kommen bevorzugt ein Polymethacrylat und/oder Urethandi-Acrylat-Oligomer in Betracht, wobei weiter bevorzugt als Komponente a) das (Meth-)acrylat Monomer zu 50 bis 69,7 Gew.-% und das (Meth-)acrylat Oligomer zu 30 bis 49,7 Gew.-% vorliegen, und zu (b) 0,05 bis 2,0 Gew.-% mindestens ein Photoinitiator und gegebenenfalls ein Aktivator und zu (c) 0,02 bis 7,0 Gew.-% mindestens ein heißhärtender Initiator, insbesondere zu 0,04 bis 5,5 Gew.-%, weiter bevorzugt zu 0,05 bis 5,00 Gew.-% in Bezug auf die Gesamtzusammensetzung von 100 Gew.-%; oder ad 100 Gew.-% mit einem Gehalt an Farbstoff, Pigment und/oder Füllstoffe, insbesondere Füllstoff.

Je nach gewünschten Eigenschaften des Schmuckgegenstandes oder der Beschichtung wie auch der Dicke der Beschichtung kann der Gehalt an Füllstoff, Pigment und/oder Farbstoff für jede Anwendung gezielt eingestellt werden.

Eine weitere bevorzugt verwendete Zusammensetzung umfasst zu (a) 60 bis 99,7 Gew.-% mindestens einer Mischung von Methacrylat Monomere mit mindestens zwei Methacrylat-Gruppen, wobei Triethylenglykoldimethacrylat, 2,2-Bis-4-(3-methacryloxy-2-hydroxy- propoxy)-phenylpropan (Bis-GMA), Triehtylenglykol-dimethacrylat und/oder ein Urethanmethacrylat mit mindestens zwei Methacrylat-Gruppen oder eine Mischung enthaltend eines der Methacrylate besonders bevorzugt sind, und (b) 0,05 bis 2,0 Gew.-% Photoinitiator und Aktivator und (c) 0,02 bis 7,0 Gew.-% heißhärtenden Initiator, insbesondere 0,04 bis 5,5 Gew.-% heißhärtenden Initiator, in der Gesamtzusammensetzung (100 Gew.-%).

Eine weitere bevorzugt verwendete Zusammensetzung umfasst zu (a) 70 bis 90 Gew.-%, insbesondere 80 bis 90 Gew.-% (Meth-)acrylat, bevorzugt 80 bis 90 Gew.-% (Meth-) acrylat, besonders bevorzugt mindestens ein Methacrylat mit mindestens zwei Methyacrylat-Gruppen, wobei Triethylenglykoldimethacrylat, 2,2-Bis-4-(3-methacryloxy-2-hydroxy-propoxy)-phenylpropan (Bis-GMA) und/oder ein Urethanmethacrylat mit mindestens zwei Methacrylat-Gruppen oder eine Mischung enthaltend eines der Methacrylate besonders bevorzugt sind,
(b) 0,05 bis 2,0 Gew.-% Photoinitiator und Aktivator und
(c) 0,02 bis 7,0 Gew.-% heißhärtenden Initiator, insbesondere 0,04 bis 5,5 Gew.-% heißhärtenden Initiator, und zu
(d) 0,03 bis 5,0 Gew.-% Farbstoff und/oder Pigment, zu
(e) 9,0 bis 25,0 Gew.-% Füllstoff, insbesondere 9,0 bis 19,0 Gew.-% Füllstoff, in Bezug auf die Gesamtzusammensetzung von 100 Gew.-%.

Zusammensetzungen mit einem Gehalt an AIBN und/oder AMBN von 0,05 bis 5,00 Gew.-% in der Gesamtzusammensetzung härten beispielsweise bei der Heißhärtung bei 130 °C innerhalb von 1 bis 15 Minuten aus. Ein weiterer Vorteil der verwendeten dualhärtenden Zusammensetzung ist, dass sie auch im Bereich von Hinterschneidungen von Schmuckgegenständen aufgrund der Heißhärtung aushärten. Dadurch wird erstmals die Herstellung formschlüssig befestigter Dekorationen an Schmuckstücken möglich, ohne die Probleme einer üblichen Heißhärtung in Gegenwart von flüssigen Wärmeträgermedien.

Zur Einstellung des Fließverhaltens der Zusammensetzung kann der Zusammensetzung ein Füllstoff zugesetzt werden. Über den Gehalt und den gewählten Füllstoff kann das Fließverhalten der Zusammensetzung gezielt eingestellt werden, so dass mit ihr auch komplizierte dekorative Elemente, wie z.B. ringförmige Strukturen oder verästelte Strukturen, geformt werden können. Durch die Wahl und den Gehalt an Füllstoff kann die Viskosität und das Verhalten der Zusammensetzung für ein leichtes Aufbringen und Verteilen auf einem Substrat oder einem Schmuckgegenstand gewählt werden. Beispielsweise soll ein Abtropfen oder Wegfließen der Zusammensetzung unterbunden werden. Auch angestrebte mechanische Eigenschaften der ausgehärteten Zusammensetzungen, wie hohe Härte und Festigkeit, lassen sich über die Wahl und den Gehalt des Füllstoffes einstellen, da man bestrebt ist besonders harte und feste ausgehärtete Zusammensetzungen als Schmuckgegenstand zu erhalten.

Als Füllstoffe eignen sich generell partikuläre organische temperaturstabile Füllstoffe oder auch partikuläre anorganische Füllstoffe. Besonders bevorzugte Füllstoffe sind Quarz-Pulver, Glas-Pulver, Glasmehl, Quarzmehl, Glaskeramik-Pulver, Aluminiumoxid, Siliciumoxid, insbesondere pyrogene und/oder gefällte Kieselsäure. Besonders bevorzugte Füllstoffe sind Glaspulver, z.B. Bariumglas-, Bariumsilikatglas-, Lithium- oder Aluminium-Silikatglas-Pulver und feinstteilige Kieselsäuren, wie pyrogene oder gefällte Kieselsäuren. Der Füllstoff kann vorzugsweise silanisiert sein, um eine bessere Dispergierung in den (Meth-)acrylaten zu ermöglichen. Die Füllstoffe liegen vorzugsweise mit einem Gehalt von 9 bis 25 Gew.-%, insbesondere mit 9 bis 19 Gew.-% in der nicht ausgehärteten Zusammensetzung. Die Teilchengröße der Füllstoff liegt in der Regel zwischen 05 bis 10 µm.

Um die gewünschten optischen Eigenschaften der ausgehärteten Zusammensetzung hinsichtlich Farbe und Erscheinungsbild variieren zu können oder auch, um besonders authentisch das Erscheinungsbild farbiger Edelsteine oder Halbedelsteine nachzuahmen, kann eine erfindungsgemäß verwendete Zusammensetzung vorzugsweise einen Farbstoff und/oder ein Pigment enthalten. Der Farbstoff oder das Pigment kann ausgewählt sein aus organischen und/oder anorganischen Farbstoffen und Pigmenten, insbesondere Calciumcarbonat; wie Marmor, Kreide; Titandioxid, Berlinerblau, vorzugsweise Pigmentblau 27 C.I. 77510; Brillantgelb, insbesondere organisch; vorzugsweise Pigmentgelb 74 C.I. 11741; Chromoxidgrün; vorzugsweise Pigmentgrün 17 C.I. 77288; Eisenoxidschwarz; Pigmentschwarz 11 C.I. 77499; Manganviolett; Pigmentviolett 16 C.I. 77742; Phthalocyaninblau, insbesondere organisch; Pigmentblau 15 C.I. 74160; Titanweiß; Pigmentweiß C.I. 77891; Ultramarinblau dunkel, vorzugsweise Pigmentblau 29 C.I. 77007; Ultramarinrot A, vorzugsweise Pigmentrot 259 C.I. 77007. Ebenfalls bevorzugte Farbstoffe und/oder Pigmente sind beispielsweise: schwarz: Microlith schwarz C-T, carbon black pigment (preparation) C.I. Pigment black 7 No. 77266; weiss: Titandioxid; rot: Microlith rot BR-T, C.I. Pigment red 144 Azo condensation pigment (preparation), Eisenoxid Pigment, BASF; grün: Cosmenyl Grün GG, Pigment green 7, C.I.No. 74260, perlweiss: Iriodin 120 Glanzsatin, Merck; blau: Ultramarin Blau L 6498, BASF.

Dem Fachmann ist klar, dass auch Glimmer oder andere, dem Fachmann hinlänglich bekannte Pigmente oder Farbstoffe der Zusammensetzung zugesetzt werden können, um die optischen Effekte der ausgehärteten Zusammensetzung hinsichtlich Farbe, Leuchtkraft, Reflexionsvermögen, oder auch Fluoreszenz einzustellen.

Dabei weisen die Farbstoffe und Pigmente vorzugsweise eine Partikelgröße im Bereich von 0,1 µm bis 8 µm auf oder liegen molekulardispers verteilt in der Zusammensetzung vor.

Der Gehalt der Farbstoffe und/oder Pigmente in der Zusammensetzung liegt vorzugsweise zwischen 0,03 bis 5,0 Gew.-%, insbesondere zwischen 0,03 bis 2,5 Gew.-% bezogen auf die Gesamtzusammensetzung.

Zusätzlich können der Zusammensetzung weitere Zusätze, wie Polymerisationsinhibitoren, z.B. Hydrochinonmonomethylether (MEHQ), und Lichtstabilisatoren zugesetzt werden.

Nach einem bevorzugten Verfahren wird die Zusammensetzung hergestellt, indem in Bezug auf die Gesamtzusammensetzung (a) 60 bis 99,7 Gew.-% (Meth-)acrylat, insbesondere 70 bis 90 Gew.-% (Meth-)acrylat, vorzugsweise 80 bis 90 Gew.-% (Meth-) acrylat; bevorzugt mindestens ein Methacrylat, besonders bevorzugt mindestens ein Methacrylat mit mindestens zwei Methyacrylat-Gruppen, wobei Triethylenglykol-dimethacrylat, 2,2-Bis-4-(3-methacryloxy-2-hydroxy-propoxy)-phenylpropan (Bis-GMA) und/oder ein Urethanmethacrylat mit mindestens zwei Methacrylat-Gruppen oder eine Mischung enthalten eines der Methacrylate besonders bevorzugt sind, und (b) 0,05 bis 2,0 Gew.-% Photoinitiator und gegebenenfalls Aktivator und (c) 0,02 bis 7,0 Gew.-% heißhärtender Initiator, insbesondere 0,04 bis 5,5 Gew.-% heißhärtender Initiator; auf 100 Gew.% zusammengegeben werden oder alternativ ad 100 Gew.-% Farbstoff, Pigment und/oder Füllstoff zusammengegeben werden, bevorzugt gemischt werden. Bevorzugt wird der Zusammensetzung mindestens ein Gehalt an Füllstoff zugesetzt. Dabei ist es weiter bevorzugt, wenn die Zusammensetzung zu (d) 0,03 bis 5,0 Gew.-% mindestens einen Farbstoff und/oder Pigment; und zu (e) 9,0 bis 25,0 Gew.-% einen Füllstoff, insbesondere zu 9,0 bis 19,0 Gew.-% Füllstoff, in Bezug auf die Gesamtzusammensetzung enthält.

Dem Fachmann ist klar, dass zur Herstellung optisch ansprechender ausgehärteter Schmuckgegenstände eine homogene Verteilung der Komponenten der Zusammensetzung notwendig ist. Daher werden die Komponenten der Zusammensetzung innig miteinander gemischt.

Gegenstand der Erfindung ist die Verwendung einer dualhärtbaren Zusammensetzung zur Dekoration oder Beschichtung eines Materials, einer Oberfläche, eines Gegenstandes, insbesondere von metallischen Gegenständen, bevorzugt von Schmuckgegenständen, Werkzeugen oder medizinischen Instrumenten, indem die Zusammensetzung auf den zu dekorierenden oder zu beschichtenden Gegenstand aufgebracht wird, mit Licht vor-polymerisiert wird, insbesondere zur Fixierung der Zusammensetzung auf dem Gegenstand, und nachfolgend bei erhöhter Temperatur heißgehärtet wird.

Hervorzuheben ist, dass mit den erfindungsgemäß verwendeten Zusammensetzungen nun auch besonders dicke und zugleich stark pigmentierte Dekorationen auf Schmuckgegenständen, wie flächige, dicke Beschichtungen oder sogar dreidimensionale Verzierungen auf einem Substrat oder einem Gegenstand aufgebracht werden können. Mit der erfindungsgemäß verwendeten Zusammensetzung können vorzugsweise ausgehärtete Schichtdicken von größer 1 mm, insbesondere Beschichtungen mit Schichtdicken von 1 bis 5 mm hergestellt werden, insbesondere eine Beschichtung oder Verzierung, auf einem Substrat oder Gegenstand aufgebracht werden. Dies ist mit der erfindungsgemäß verwendeten Zusammensetzung selbst mit stark pigmentierten, dunklen oder opaken Zusammensetzungen möglich, da durch die Dualhärtung erstmals eine Licht induzierte Vor-Polymerisation eintritt und eine Aushärtung der Zusammensetzung erst bei erhöhter Temperatur vorzugsweise zwischen 30 bis 90 °C, bevorzugt bei 40 bis 70 °C, besonders bevorzugt um 60 °C erfolgt. Eine Auftragung einer ausgehärten Zusammensetzung größer 5 mm Schichtdicke wird nicht mehr als eine Beschichtung/Schicht angesehen.

Ebenfalls Gegenstand der Erfindung ist die Verwendung einer Zusammensetzung zur Beschichtung Dekoration und Markierung von Schmuckmaterialien, zur Herstellung von Schmuckgegenständen, insbesondere von dreidimensionalen Schmuckgegenständen, -artikeln oder von beschichteten Schmuckgegenständen sowie; und zur Herstellung farbiger Überzüge oder Markierungen oder Beschriftungen auf Werkzeug oder medizinischen Instrumenten, insbesondere zur Markierung dieser oder für eine leichtere Identifizierbarkeit. Bevorzugt wird dabei die Vor-Polymerisation der Zusammensetzung mit Licht im UV/Vis-Bereich induziert, insbesondere im Wellenlängenbereich von 350 bis 600 nm, wobei die Photoinitiatoren vorzugsweise wellenlängenselektiv sind, wie bspw. gemäß einer Alternative zwischen 400 bis 500 nm eine Vor-Polymerisation bewirken.

Besondere Schwerpunkte bilden dabei die Beschichtung von Schmuck, die Beschichtung stark gekrümmter Gegenstände - wie Ringe oder Drähte - und die Beschichtung zur Kennzeichnung medizinischer Gegenstände, insbesondere auch hier stark gekrümmter Gegenstände wie z.B. Sonden. Dabei kommt der Vorteil der erfindungsgemäßen Verwendung zum Tragen, nämlich daß Spannungen die bei der Photohärtung entstehen, bei der thermischen Härtung wieder abgebaut werden.

Ein besonderer Vorteil der Dualhärtung ist die Form-Fixierung durch die Licht induzierte Vor-Polymerisation und die anschließende, zu einem späteren Zeitpunkt, erfolgende Heißpolymerisation. Dies ist ein besonderer Vorteil bei der Herstellung einer hohen Stückzahl an unterschiedlichen Schmuckobjekten. So können viele Teile einzeln hergestellt werden und diese werden anschließend zusammen in einem einzigen Arbeitsgang endgültig heiß gehärtet.

Erfindungsgemäß können Substrate, Materialien, Werkzeuge, medizinische Instrumente oder metallische Substrate, metallische Schmuckgegenstände, wie Ringe, Broschen, Anstecker, Armbänder, Plaketten und Uhren, mit der Zusammensetzung versehen werden oder auch mit der vor-polymerisierten Zusammensetzung dekoriert, d.h. mit dekorativen Elementen versehen werden. Anschließend kann die vollständige Aushärtung der Elemente auf den Schmuckgegenständen im Wärmeofen erfolgen. Auch zur Nachbildung verloren-gegangener Edelsteine oder Halbedelsteine an bspw. Uhren, Schmuck oder Modeschmuck kann die Erfindung benutzt werden.

Bei der erfindungsgemäßen Verwendung wird die Zusammensetzung auf ein Substrat, ein Material oder den zu dekorierenden Gegenstand aufgebracht. Alternativ kann der zu dekorierende Bereich des Gegenstandes zunächst mit einem Haftvermittler, wie bspw. einem Haftvermittler für Metall und/oder Kunststoff versehen werden, vorzugsweise auf Basis eines Methacryloyloxydecyl-dihydrogenphosphats oder hydrophoben Dimethacrylats mit Benzoylperoxid. Im nächsten Schritt kann die Zusammensetzung darauf angebracht werden. Zweck des Haftvermittlers ist die Ausbildung eines festen Verbundes zwischen Metalloberfläche und aufgetragenem Material.

Die Konsistenz kann durch den Füllstoffgehalt so eingestellt sein, dass sie einerseits ein vollständiges und schnelles Bedecken des zu dekorierenden Bereiches erlaubt und andererseits nicht aus diesem Bereich wegfließt oder abtropft. Ebenfalls soll die Konsistenz so eingestellt sein, dass sich vorzugsweise beim Auftragen keine Luftblasen in der nicht ausgehärteten Zusammensetzung bilden. Um optisch Edelsteine am nächsten nachzubilden, sind die Zusammensetzungen vorzugsweise transparent und im Wesentlichen blasenfrei. Abhängig von den, der Zusammensetzung gegebenenfalls zugesetzten Farbstoffen können z.B. Saphire, Rubine oder Smaragde nachgeahmt werden.

Ein zu dekorierender Bereich eines Schmuckgegenstandes kann in der gewünschten Weise mit der Zusammensetzung versehen werden. Anschließend wird die Zusammensetzung mit UV/Vis-Licht vor-polymerisiert und nachfolgend bei 130 °C ausgehärtet. Hierbei kann in vorteilhafter Weise so vorgegangen werden, dass in einem ersten Schritt mittels eines Lichthandgerättes die Zusammensetzung vor-polymerisiert wird, um auf diese Weise eine Fixierung auf dem Gegenstand zu erzielen. Aufgrund der hohen Reaktivität der Zusammensetzung reicht in der Regel eine Bestrahlung mit Licht für ca. 5-10 Sekunden. Durch die kurze Belichtungszeit ist es für den Goldschmied möglich, sofort nach Fertigstellung eines dekorativen Elementes dieses schnell zu fixieren. Anschließend kann der dekorierte Schmuckgegenstand in einen üblichen Wärmeofen gelegt werden und bei Temperaturen zwischen 30 bis 150 °C ausgehärtet werden. Bei 130 °C ist der dekorierte Schmuckgegenstand je nach Gehalt des heißhärtenden Initiators zwischen 0,05 bis 5,00 Gew.-% innerhalb von 4 bis 10 Minuten ausgehärtet. Als Lichthandgerät und Lichtpolymerisationsgerät können im dentalen Bereich eingesetzte Geräte verwendet werden. Bevorzugt wird die Licht induzierte Polymerisation mittels Blaulicht durchgeführt.

Nach der Aushärtung zeigt die Zusammensetzung einen sehr guten Glanz, und weist durch den Abbau der mechanischen Spannungen während der Heißpolymerisation erhöhte mechanische Eigenschaften als entsprechende, rein mit Licht polymerisierte Zusammensetzungen, auf. Zudem ist die ausgehärtete Zusammensetzung tiefentransparent und ästhetisch sehr ansprechend. Die erhöhte Härte zeigt sich in der verbesserten Kratzfestigkeit.

Gegenstand der Erfindung ist auch die Verwendung einer dualhärtenden Zusammensetzung derart, dass diese nach der Dualhärtung eine Biegefestigkeit (Bruchfestigkeit) von größer 110 MPa (N/mm²), insbesondere zwischen 120-160 MPa (N/mm²), eine Druckfestigkeit größer 300 MPa (N/mm²), insbesondere zwischen 350-450 MPa (N/mm²) und/oder ein E-Modul (Sprödigkeit) von größer 3500 MPa (N/mm²), insbesondere zwischen 4000-5200 MPa (N/mm²) aufweist, sowie die Verwendung für dualgehärtete Beschichtungen, Dekorationen, Markierungen und/oder Beschriftungen, die erhältlich sind aus der dualhärtenden Zusammensetzung.

Bei Bedarf kann die ausgehärtete Zusammensetzung geschliffen werden, um ihr Aussehen dem von Edelsteinen weiter anzunähern. Ein Nachpolieren ist ebenfalls möglich, obwohl der Eigenglanz der gehärteten Zusammensetzung in den meisten Fällen bereits sehr hoch ist. Zudem können in einfacher Weise maschinelle Korrekturen an dem erhaltenen dekorativen Element durchgeführt werden.

Nachfolgend wird die Erfindung anhand von Beispielen näher erläutert, ohne sie auf die Beispiele zu beschränken:

### Beispiele

Zunächst wurden die nachstehend angegebenen ungefärbten Zusammensetzungen durch inniges Vermengen der einzelnen angegebenen Komponenten hergestellt: Nach dem Auftragen der Zusammensetzung wurde diese für 5 bis 10 Sekunden mit UV/Vis-Licht vor-polymerisiert und anschließend bei 130 °C im Wärmeofen ausgehärtet. Die Härtungszeit hängt u.a. von der Konzentration des heißhärtenden Initiators ab.

**Tabelle 1: Ungefärbte Grundrezeptur Zusammensetzung:**

| **Komponente** | **Gew.%** |
|---|---|
| 2,2-Bis-4-(3-methacryloxy-2-hydroxypropoxy)-phenylpropan (Bis-GMA) | 77 |
| Triethylenglykoldimethacrylat | 20 |
| Pentaerythrit-tetra-acrylat | 2 |
| D,L-Campherchinon | 0,2 |
| Lucirin (Ethyl - 2,4,6 - Trimethylbenzoylphenylphosphinate) | 0,4 |
| Additive | 0,4 |
| Summe | **100,00** |
| Es werden zusätzlich 0,5 bis 5,0 Gew.-% AIBN und/oder AMBN in Bezug auf die erhaltene Gesamtzusammensetzung von 100 Gew-% zugegeben. | |

**Tabelle 2: Ungefärbte Grundrezeptur Zusammensetzung:**

| **Komponente** | **Gew.%** |
|---|---|
| 2,2-Bis-4-(3-methacryloxy-2-hydroxypropoxy)-phenylpropan (Bis-GMA) | 77 |
| Triethylenglykoldimethacrylat | 20 |
| Pentaerythrit-tetra-acrylat | 2 |
| D,L-Campherchinon | 0,2 |
| Lucirin TPO (Ethyl - 2,4,6 - Trimethylbenzoylphenylphosphinate) | 0,4 |
| AIBN und/oder AMBN | 0,4 |
| Summe | **100,00** |
| Es werden zusätzlich 0,5 bis 5,0 Gew.-% AIBN und/oder AMBN in Bezug auf die erhaltene Gesamtzusammensetzung von 100 Gew-% zugegeben. | |

**Tabelle 3: Ungefärbte Zusammensetzung:**

| **Komponente** | **Gew.-%** |
|---|---|
| 2,2-Bis-4-(3-methacryloxy-2-hydroxypropoxy)-phenylpropan (Bis-GMA) | **33,79** |
| Urethandimethacrylat | **29,75** |
| Triethylenglykoldimethacrylat | **16,07** |
| Hydrochinonmonomethylether (MEHQ) | **0,07** |
| **D,L-Campherchinon** | **0,24** |
| Cyanoethylmethylanilin (CEMA) | **0,40** |
| Feinstteilige Kieselsäure (Aerosil TM) | **0,43** |
| Glaspulver, silanisiert | **14,25** |
| AIBN | **5,00** |
| Summe | **100,00** |

Nach dem Auftragen der Zusammensetzung wurde diese für 5 bis 10 Sekunden mit UV/Vis-Licht vor-polymerisiert und anschließend bei 130 °C im Wärmeofen ausgehärtet. Die Härtung war nach 4 Minuten abgeschlossen.

**Tabelle 4: Ungefärbte Zusammensetzung:**

| **Komponente** | **Gew.%** |
|---|---|
| 2,2-Bis-4-(3-methacryloxy-2-hydroxypropoxy)-phenylpropan (Bis-GMA) | **35,55** |
| Urethandimethacrylat | **31,29** |
| Triethylenglykoldimethacrylat | **16,92** |
| Hydrochinonmonomethylether (MEHQ) | **0,08** |
| **D,L-Campherchinon** | **0,25** |
| Cyanoethylmethylanilin (CEMA) | **0,42** |
| Feinstteilige Kieselsäure (Aerosil TM) | **0,45** |
| Glaspulver, silanisiert | **14,99** |
| AIBN | **0,05** |
| Summe | **100,00** |

Nach dem Auftragen der Zusammensetzung wurde diese für 5 bis 10 Sekunden mit UV/Vis-Licht vor-polymerisiert und anschließend bei 130 °C im Wärmeofen ausgehärtet. Die Härtung war nach 10 Minuten abgeschlossen.

**Tabelle 5: Zusammensetzungen entsprechend den Tabellen 3 und 4 mit quantitativ angepassten Gehalten der Komponenten unter Berücksichtigung der AIBN Gehalte mit Angabe der Zeiten für die Aushärtung**

| **Gehalt AIBN (Gew.-%)** | **Härtzeit bei 130 °C im Wärmeofen in Minuten** |
|---|---|
| 0,10 | 9 |
| 0,20 | 8 |
| 0,40 | 8 |
| 0,50 | 8 |
| 0,80 | 7 |
| 1,00 | 7 |
| 2,00 | 6 |
| 3,00 | 5 |

Der ungefärbten Zusammensetzung gemäß Tabelle 3 können entsprechend nachstehender Farbstoffe oder Pigmente zugegeben, um z.B. einen Saphir, einen Smaragd, einen Rubin oder einen Amethyst nachzuahmen.

**Tabelle 6: Vergleichsbeispiel ohne heißhärtenden Initiator**

| **Komponente** | **Gew.-%** |
|---|---|
| 2,2-Bis-4-(3-methacryloxy-2-hydroxypropoxy)-phenylpropan (Bis-GMA) | **35,35** |
| Urethandimethacrylat | **31,28** |
| Triethylenglykoldimethacrylat | **16,92** |
| Hydrochinonmonomethylether (MEHQ) | **0,08** |
| **D,L-Campherchinon** | **0,25** |
| Cyanoethylmethylanilin (CEMA) | **0,42** |
| UV-Stabilisator (Tinuvin P, Ciba Geigy) | **0,25** |
| Feinstteilige Kieselsäure (Aerosil TM) | **0,45** |
| Glaspulver, silanisiert | **15,00** |
| Summe | **100,00** |

**Tabelle 7: Eigenschaften ausgehärteter Beschichtungen**

| | bspw. gemäß Vergleichsbeispiel | erfindungsgemäß |
|---|---|---|
| | Lichthärtung | Dualhärtung |
| Biegefestigkeit (Bruchfestigkeit) | 80 - 100 MPa (N/mm²) | 120-160 MPa (N/mm²) |
| Druckfestigkeit | 200-280 MPa (N/mm²) | 350-450 MPa (N/mm²) |
| E-Modul (Spödigkeit) | 2500-3200 MPa (N/mm²) | 4000-5200 MPa (N/mm²) |

## Patentansprüche

1. Verwendung einer dualhärtenden polymerisierbaren Zusammensetzung, umfassend
• mindestens ein (Meth-)acrylat,
• eine Kombination umfassend mindestens einen Photoinitiator und heißhärtenden Initiator,
• einen Gehalt an Pigment oder Farbstoff
• gegebenenfalls einen Gehalt an Füllstoff,
die stark pigmentiert dunkel oder opak ist,
Herstellung dreidimensionaler Schmuckgegenstände, dreidimensionaler Schmuckartikel oder zur Beschichtung, Dekoration, Markierung und/oder Beschriftung eines Substrates aus der Gruppe der Schmuckgegenstände, Werkzeuge oder medizinischen Instrumente.

2. Verwendung nach Anspruch 1, zur Beschichtung stark gekrümmter Gegenstände aus der Gruppe der Schmuckgegenstände, Werkzeuge oder medizinischen Instrumente.

3. Verwendung nach Anspruch 1 oder 2, **dadurch gekennzeichnet, dass** der Photoinitiator eine Carbonyl-funktionalisierte Verbindung umfasst.

4. Verwendung nach Anspruch 1 oder 2, **dadurch gekennzeichnet, dass** der heißhärtende Initiator ein Azo-bis-Alkylnitril ist, und die beiden Alkylsubstituenten jeweils unabhängig 3 bis 15 C-Atome aufweisen, insbesondere AIBN (Azo-bis-isobutyronitril, 2,2'-Azobis(2-methylpropionitril)) und/oder AMBN (2,2'-Azo-bis(2-Methylbutyronitril).

5. Verwendung nach einem der Ansprüche 1 bis 4, **dadurch gekennzeichnet, dass** die Zusammensetzung mindestens ein Monomer eines (Meth-)acrylats mit einem mit aromatischen und/oder aliphatischen Kohlenwasserstoffgrundgerüst ist oder mit einem Alkylenoxy-Grundgerüst mit 2 bis 4 C-Atomen in jeder Alkylen-Gruppe ist, insbesondere ein (Meth-)acrylat mit mindestens zwei (Meth-)acrylat-Endgruppen.

6. Verwendung nach einem der Ansprüche 1 bis 5, **dadurch gekennzeichnet, dass** die Zusammensetzung mindestens ein Methacrylat, insbesondere ein Methacrylat mit mindestens zwei Methacrylat-Gruppen enthält.

7. Verwendung nach Anspruch 6, **dadurch gekennzeichnet, dass** das Methacrylat mit mindestens zwei Methacrylat-Gruppen ausgewählt ist aus Tetraethylenglykoldimethacrylat, Diethylenglykoldimethacrylat, Ethylenglykoldimethacrylat, Polyethylenglykoldimethacrylat, Butandioldimethacrylat, Hexandioldimethacrylat, Decandioldimethacrylat, Dodecandioldimethacrylat, Bisphenol-A-dimethacrylat, Pentaerythrit-tetra-Methacrylat, und/oder Trimethylolpropantrimethacrylat.

8. Verwendung nach einem der Ansprüche 6 bis 7, **dadurch gekennzeichnet, dass** das Methacrylat mit mindestens zwei Methacrylat-Gruppen ausgewählt ist aus Triethylenglykoldimethacrylat, 2,2-Bis-4-(3-methacryloxy-2-hydroxy-propoxy)-phenylpropan (Bis-GMA) und/oder ein Urethanmethacrylat mit mindestens zwei Methacrylat-Gruppen oder einer Mischung enthaltend mindestens eines der Methacrylate.

9. Verwendung nach einem der Ansprüche 1 bis 8, **dadurch gekennzeichnet, dass** der Photoinitiator ein Benzophenon oder ein Benzophenon-Derivat, Benzoin oder ein Benzoin-Derivat, Diphenyl(2,4,6,-trimethylbenzoyl)phosphinoxid, ein alpha-Diketon, ein Acylphosphinoxid, Diacetyl, Furil, Anisil, 4,4'-Dichlorbenzil, 4,4'-Dialkoxybenzil und/oder Campherchinon umfasst.

10. Verwendung nach einem der Ansprüche 1 bis 9, **dadurch gekennzeichnet, dass** die Zusammensetzung
(a) 60 bis 99,7 Gew.-% (Meth-)acrylat, insbesondere 80 bis 90 Gew.-% (Meth-)acrylat,
(b) 0,05 bis 2,0 Gew.-% Photoinitiator und gegebenenfalls Aktivator und
(c) 0,02 bis 7,0 Gew.-% heißhärtenden Initiator, insbesondere 0,04 bis 5,5 Gew.-% heißhärtenden Initiator sowie ad 100 Gew.-% gegebenenfalls Füllstoff enthält.

11. Verwendung nach einem der Ansprüche 1 bis 10, **dadurch gekennzeichnet, dass** der Füllstoff Quarz-Pulver, Glas-Pulver, Glasmehl, Quarzmehl, Glaskeramik-Pulver, Aluminiumoxid, Siliciumoxid, insbesondere pyrogene und/oder gefällte Kieselsäure umfasst, insbesondere ist der Füllstoff silanisiert.

12. Verwendung nach einem der Ansprüche, 1 bis 11, **dadurch gekennzeichnet, dass** sie nach der Dualhärtung eine Biegefestigkeit (Bruchfestigkeit) von größer 110 MPa (N/mm²), insbesondere zwischen 120-160 MPa (N/mm²), eine Druckfestigkeit größer 300 MPa (N/mm²), insbesondere zwischen 350-450 MPa (N/mm²) und/oder ein E-Modul (Spödigkeit) von größer 3500 MPa (N/mm²), insbesondere zwischen 4000-5200 MPa (N/mm²) aufweist.

13. Verwendung nach einem der Ansprüche 1 bis 12, **dadurch gekennzeichnet, dass** mit der Zusammensetzung eine ausgehärtete Schichtdicke von größer 0,1 mm bis bspw. 5 mm aufgebracht wird, insbesondere 1 mm bis 5 mm, bevorzugt 1,1 bis 4 mm.

14. Verfahren zur Beschichtung, Dekoration, Markierung und/oder Beschriftung eines aus der Gruppe der Schmuckgegenstände, Werkzeuge oder medizinischen Instrumente, indem die Zusammensetzung auf den zu dekorierenden Gegenstand aufgebracht wird,
- mit Licht vorpolymerisiert wird, insbesondere zur Fixierung der Zusammensetzung auf dem Gegenstand,
- nachfolgend durch Wärme heißgehärtet wird.

15. Verfahren nach Anspruch 14, zur Beschichtung, Dekoration, Markierung und/oder Beschriftung stark gekrümmter Gegenstände aus der Gruppe der Schmuckgegenstände, Werkzeuge oder medizinischen Instrumente.
